# DEMANDE DE BREVET EUROPEEN

(11) **EP 4 415 267 A1**
(43) Date de publication de la demande: **14.08.2024**
(21) Numéro de dépôt: 23155972.5
(22) Date de dépôt: 10.02.2023
(51) Int. Cl.: H03L 3/00, H03L 7/085, H03L 7/099, H03L 7/07

(54) **PROCEDE DE MISE EN ACTION D'UN SYSTEME OSCILLATEUR A DEMARRAGE RAPIDE, ET SYSTEME OSCILLATEUR A DEMARRAGE RAPIDE**

(71) Demandeur: The Swatch Group Research and Development Ltd, 2074 Marin (CH)
(72) Inventeur: CASAGRANDE, Arnaud, 2014 Bôle (CH); AREND, Jean-Luc, 2035 Corcelles (CH)
(74) Mandataire: ICB SA

(57) **Abrégé**

L'invention propose un procédé de mise en action d'un système oscillateur (10) à démarrage rapide, qui comprend un oscillateur de référence (45) et un oscillateur à quartz (12) lié à un circuit oscillateur électronique, qui est prévu pour fournir un signal d'horloge maître à un contrôleur de démarrage configuré pour effectuer une procédure à démarrage rapide de l'oscillateur à quartz par l'intermédiaire de l'oscillateur de référence. Le contrôleur de démarrage comprend une unité de calcul (25) et une unité mémoire (26) pour le stockage de données en liaison à l'oscillateur de référence pour le démarrage de l'oscillateur à quartz. Le procédé comprend des étapes, pendant une durée de démarrage de l'oscillateur à quartz consistant à paramétrer l'unité de calcul pour le démarrage de l'oscillateur à quartz, à générer dans différentes périodes successives dans une durée de démarrage de l'oscillateur à quartz des impulsions d'excitation à fournir à l'oscillateur à quartz pour le faire osciller, et un temps de réalignement de phases, à déterminer un écart de phases dans différentes périodes successives entre l'oscillation de l'oscillateur de référence et l'oscillation de l'oscillateur à quartz, à calculer une erreur de fréquences dans l'unité de calcul sur la base de l'écart de phases ou de la dérivée de la pente de variations de phases, et à corriger la fréquence de l'oscillateur de référence à la fréquence de l'oscillateur à quartz dans une marge d'erreur limitée.

## Description

### DOMAINE TECHNIQUE

L'invention se rapporte à un procédé de mise en action d'un système oscillateur, ayant un oscillateur à quartz et un oscillateur de référence, à démarrage rapide avec un asservissement en phase.

L'invention se rapporte également à un système oscillateur destiné à être mis en action par le procédé d'entraînement.

### ARRIERE-PLAN TECHNOLOGIQUE

Dans un système à oscillateur à quartz à démarrage rapide, tel que décrit dans les demandes de brevet EP 3 965 290 A1 ou EP 3 965 291 A1, la fréquence d'un oscillateur de référence de type CMOS est calibrée lors de la phase de test après l'assemblage du circuit. Cette fréquence possède une certaine erreur par rapport à celle de l'oscillateur à quartz, et cette erreur tend à se modifier naturellement au cours du temps selon les différentes conditions PVT du circuit intégré, et également selon les critères de vieillissement du quartz utilisé.

Le brevet US 10,951,166 B1 décrit un circuit oscillateur générant un signal de tension oscillant une fois mis en fonction. Le quartz de l'oscillateur a une première électrode et une seconde électrode. Le circuit oscillateur a une source d'alimentation avec une borne d'alimentation et une borne de référence. Le circuit oscillateur comporte un circuit de commutation, qui est agencé entre la source d'alimentation et le quartz. Le circuit de commutation, dans une phase de démarrage, connecte alternativement la borne d'alimentation de la source de tension d'alimentation à la première électrode et à la seconde électrode du quartz de manière à avoir une augmentation de l'amplitude du signal de tension oscillant. Même s'il est prévu dans ce document un démarrage rapide du circuit oscillateur, il y a néanmoins différentes commutations de l'étage oscillateur ce qui en général ne permet pas d'effectuer précisément un démarrage rapide avec une bonne précision de la fréquence d'oscillation, ce qui constitue un inconvénient.

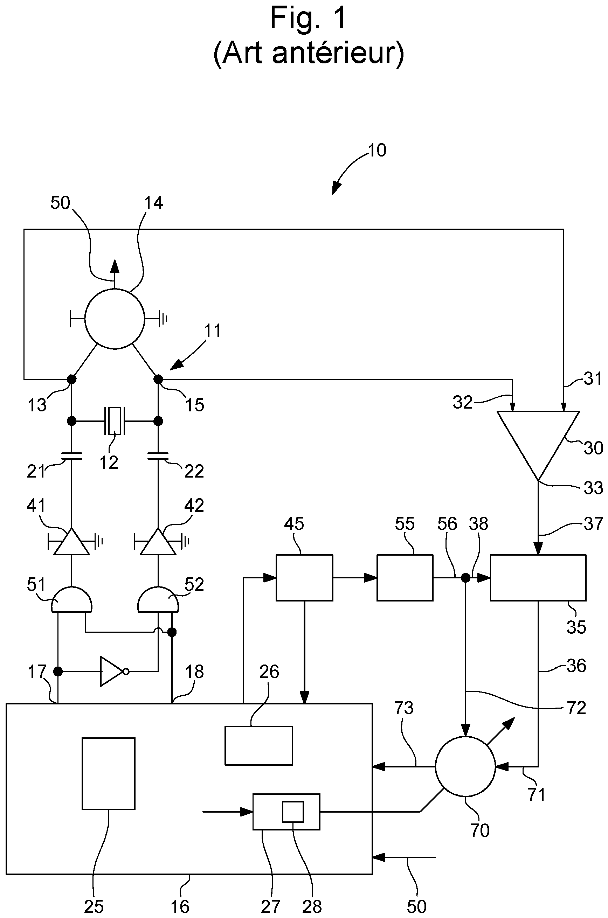

La figure 1 représente une forme d'exécution d'un système à oscillateur à quartz 10 comme décrit dans la demande de brevet EP 3 965 291 A1. L'oscillateur 11 comprend un résonateur à quartz 12 lié à un circuit oscillateur électronique 14. Le résonateur à quartz 12 est électriquement couplé au circuit oscillateur électronique 14. Typiquement, le résonateur à quartz 12 est connecté en parallèle au circuit oscillateur électronique 14. La structure de l'oscillateur 11 comprend une première borne 13 et une seconde borne 15, qui sont connectées respectivement aux première et seconde bornes du résonateur à quartz 12 et au circuit oscillateur électronique 14. La borne de sortie 50 du circuit oscillateur électronique 14 est prévue pour fournir un signal d'horloge maître pour être utilisé par un dispositif électronique, qui peut être une montre portée par un utilisateur.

Le système à oscillateur à quartz 10 comprend en outre un contrôleur de démarrage 16 configuré et opérable pour effectuer une procédure de démarrage à oscillation rapide avec l'oscillateur à quartz 10. Le contrôleur de démarrage 16 comprend généralement un processeur 25 ainsi qu'une mémoire 26 et une mémoire supplémentaire ou de stockage 27. L'oscillateur à quartz 10 est en outre équipé d'un comparateur 30, qui comprend une première borne d'entrée 31 connectée à la première borne 13. Le comparateur comprend en outre une deuxième borne d'entrée 32 connectée à la deuxième borne 15 de la structure de l'oscillateur 11. Le signal d'horloge maître peut également être présent ou peut être renvoyé au contrôleur de démarrage 16.

Le système à oscillateur à quartz 10 comprend en outre un synchroniseur 35. Le synchroniseur 35 comprend une borne d'entrée également désignée comme une entrée de synchronisation 37 ou sortie de comparateur. L'entrée du synchroniseur 37 est directement connectée à une borne de sortie 33 du comparateur 30. De cette façon, un signal comparatif indiquant une comparaison des premier et deuxième signaux d'oscillation présents aux première et deuxième bornes 13, 15 peut être fourni au synchroniseur 35.

Le système à oscillateur à quartz 10 comprend en outre un oscillateur 45, généralement mis en oeuvre comme un oscillateur RC. Le fonctionnement de l'oscillateur 45 peut être régi par le contrôleur de démarrage 16. Ici, de nombreuses fréquences pour la conduite de l'oscillateur 45 peuvent être stockées dans l'unité de stockage 26. L'oscillateur 45 est en outre connecté ou couplé à une boucle de phase verrouillée 55 (PLL). La boucle à verrouillage de phase 55 comprend une borne de sortie 56 connectée à une entrée d'horloge 38 du synchroniseur 35. La borne de sortie 56 de la boucle à verrouillage de phase 55 ainsi qu'une borne de sortie 36 du synchroniseur 35 sont connectées individuellement ou couplées aux bornes d'entrée respectives 72, 71 d'une unité de déphasage de phase 70. Le déphasage est couplé à une mémoire numérique 27.

La mémoire numérique 27 peut être fournie avec un tableau de recherche 28. Comme indiqué sur la figure 1, l'unité de déphasage 70 est couplée au stockage numérique 27 et est donc configurée pour lire ou récupérer les données numériques stockées dans le stockage numérique 27. Généralement, les données numériques fournies par le stockage numérique indiquent ou caractérisent un délai de commutation du comparateur 30. De cette façon, le délai de commutation du comparateur 30 et donc l'effet ou l'impact de la dispersion du comparateur 30 du signal comparatif généré par le comparateur 30 peuvent être efficacement compensés par l'unité de déphasage 70. L'unité de déphasage 70 comprend une borne de sortie 73 connectée au contrôleur de démarrage 16.

Les signaux fournis à la borne de sortie 73 et renvoyés dans le contrôleur de démarrage 16 peuvent être utilisés comme signaux de synchronisation par lesquels le contrôleur de démarrage 16 et/ou son processeur 25 déclenche la génération d'un signal d'oscillation.

A la figure 1, le contrôleur de démarrage 16 comprend une sortie de phase 17 connectée à des première et deuxième portes logiques 51, 52. L'entrée de la deuxième porte logique 52 est inversée par un inverseur 60 par rapport à l'entrée de la première porte logique 51. Les deux portes logiques 51, 52 sont en outre connectées à une sortie de contrôle de démarrage 18. Une sortie des première et deuxième portes logiques 51, 52, qui sont par exemple des portes logiques ET, est connectée ou couplée aux premier et deuxième amplificateurs tampon 41, 42. Les sorties respectives des premier et deuxième amplificateurs tampon 41, 42 sont connectées aux premier et deuxième condensateurs 21, 22. Les condensateurs 21, 22 sont entraînés en mode déphasé par le contrôleur de démarrage 16.

### RESUME DE L'INVENTION

La présente invention concerne un procédé de mise en action d'un système oscillateur à démarrage rapide avec un asservissement en phase de l'oscillateur de référence en palliant les inconvénients cités de l'art antérieur.

La présente invention concerne également un système électronique mis en action par le procédé d'entraînement du système oscillateur à démarrage rapide de manière à asservir en phase pour corriger une erreur de fréquences d'un oscillateur de référence du système oscillateur en palliant les inconvénients cités de l'art antérieur.

Pour ce faire, il est tout d'abord proposé le procédé de mise en action du système oscillateur à démarrage rapide, qui comprend les caractéristiques définies dans la revendication indépendante 1.

Différentes étapes préférées du procédé de mise en action du système électronique sont définies dans les revendications dépendantes 2 à 7.

Pour ce faire, il est proposé également, le système oscillateur mis en action par le procédé d'entraînement, qui comprend les caractéristiques définies dans la revendication indépendante 8.

Des formes d'exécution particulières du système sont définies dans les revendications dépendantes 9 à 12.

Un avantage du système ou du procédé de mise en action du système oscillateur réside dans le fait que d'une part la fréquence de l'oscillateur de référence est constamment présente au cours de la phase de démarrage de l'oscillateur à quartz, c'est-à-dire que l'oscillateur de référence peut être maintenu toujours en fonction ou au moins avant le démarrage de l'oscillateur à quartz. Et d'autre part, la phase de cet oscillateur de référence est successivement réalignée avec la phase d'oscillation libre de l'oscillateur à quartz. Dans ces conditions, il est possible de n'utiliser que la variation de phase obtenue à chaque réalignement de phases pour en déduire une différence de fréquence. Ainsi cette différence de fréquence peut être utilisée pour corriger la fréquence de l'oscillateur de référence. Il est possible de corriger une marge d'erreur de fréquences de ±1 %, notamment par rapport à la fréquence de l'oscillateur à quartz en fonction.

Une fois l'oscillateur de référence corrigé en fréquence par la détermination de l'écart de phases à chaque période de réalignement de phases dans le temps de démarrage de l'oscillateur à quartz, l'oscillateur à quartz n'est plus entretenu par l'oscillateur de référence qui est de préférence un oscillateur de type RC. Par contre, un prochain démarrage de l'oscillateur à quartz sera amélioré.

Avantageusement, il est plus facile de déterminer un écart de phase entre l'oscillateur de référence et l'oscillateur à quartz et par la suite de déterminer facilement l'écart de fréquence pour corriger la fréquence d'oscillation de l'oscillateur de référence et ceci à chaque réalignement de phases. Principalement, la variation de phases obtenue à chaque réalignement de phases permet de déduire une différence de fréquence pour la correction de fréquence de l'oscillateur de référence.

Auparavant il n'avait jamais été imaginé utiliser directement l'écart de phases pour corriger directement et facilement l'écart ou erreur de fréquences entre l'oscillateur de référence et l'oscillateur à quartz. Ainsi la présente invention présente le système oscillateur dans lequel l'oscillateur de référence peut fonctionner en continu de manière à déterminer tout écart de phases entre l'oscillateur de référence et l'oscillateur à quartz pour permettre de déterminer rapidement par une dérivée l'erreur de fréquences pour corriger la fréquence de l'oscillateur de référence.

### BREVE DESCRIPTION DES FIGURES

Les buts, avantages et caractéristiques d'un système oscillateur à démarrage rapide avec un asservissement en phase ou en fréquence apparaîtront mieux dans la description suivante de manière non limitative en regard des dessins sur lesquels :
- la figure 1 représente un système à oscillateur à quartz entretenu par un oscillateur de référence de l'art antérieur,
- la figure 2 représente différentes parties du système électronique pour décrire les différentes étapes du procédé d'entraînement du système oscillateur selon la présente invention, notamment pour assurer un démarrage rapide de l'étage oscillateur à quartz de manière à mesurer ou calculer un écart de phases facilement utilisable pour la détermination d'une erreur de fréquences calculée dans une unité de calcul et à corriger,
- la figure 3 représente des signaux générés par un dispositif d'entraînement tel qu'un driver de l'étage oscillateur à quartz dans une phase de démarrage du système oscillateur selon la présente invention et dans lequel l'oscillateur de référence peut être alimenté en continu avec une adaptation de phase dans différentes étapes successives de manière à déterminer une erreur de fréquences à corriger pour garantir des signaux de l'oscillateur à quartz et de l'oscillateur de référence déterminé précisément dans une gamme d'erreur déterminée,

- la figure 4 représente une première forme d'exécution d'un système oscillateur à démarrage rapide avec asservissement en phase du type analogique multi-phase de la présente invention, le système oscillateur comprenant un oscillateur de référence de type RC multi-phase,
- la figure 5 représente une seconde forme d'exécution d'un système oscillateur à démarrage rapide de type numérique multi-phase avec un asservissement en phase de la présente invention, le système oscillateur comprenant l'oscillateur de référence de type RC multi-phase avec une boucle à verrouillage de phase à multiplication de fréquence,
- la figure 6 représente une troisième forme d'exécution d'un système oscillateur à démarrage rapide avec un asservissement en phase de la présente invention, le système oscillateur comprenant l'oscillateur de référence de type RC multi-phase et avec un dispositif à retard de phase, et
- la figure 7 représente une quatrième forme d'exécution d'un système oscillateur à démarrage rapide de type analogique à phase unique avec un asservissement en phase de la présente invention, le système oscillateur comprenant un oscillateur de type RC avec un mélangeur IQ de synchronisation.

### DESCRIPTION DETAILLEE DE L'INVENTION

Dans la description suivante, il est décrit tous les composants d'un système oscillateur à démarrage rapide et asservissement principalement en phase pour permettre de corriger une erreur de fréquences d'un oscillateur de référence sur la base d'un oscillateur à quartz à mettre en fonction par l'intermédiaire de l'oscillateur de référence et d'un contrôleur de démarrage. Il est principalement recherché dans cette présente invention de mesurer un écart de phases dans des périodes successives d'entraînement ou d'excitation lors du démarrage de l'oscillateur à quartz de manière à corriger une erreur de fréquences entre la fréquence de l'oscillateur à quartz et la fréquence de l'oscillateur de référence. Il est donc prévu un procédé de contrôle et d'adaptation de la phase de manière à déterminer cette erreur de fréquences pour la correction éventuelle de la fréquence de l'oscillateur de référence si l'erreur de fréquences est au-dessus ou au-dessous d'un seuil déterminé. Pour ce faire, il est utilisé la variation de phases pendant des périodes successives dans une durée de démarrage de l'oscillateur à quartz pour déterminer une erreur de fréquences par une opération de dérivée d'écarts de phases dans ces périodes successives. Principalement l'erreur de fréquences est obtenue par une dérivée de la pente de variation de phases ceci après chaque réalignement de phases ou plusieurs réalignements de phases dans des périodes successives dans au moins une partie de la durée de démarrage de l'oscillateur à quartz. Comme indiqué précédemment, l'oscillateur de référence peut rester continuellement en fonction si une alimentation électrique du système oscillateur est suffisante pour le maintenir en fonction.

Dans les documents de l'art antérieur, même si l'oscillateur de référence reste en fonction continuellement comme présenté dans le système oscillateur de la figure 1, il n'est nullement imaginé d'utiliser la variation de phases pour déterminer et corriger par la suite directement la fréquence notamment de l'oscillateur de référence pour être dans une marge d'erreur limitée par rapport à la fréquence de l'oscillateur à quartz. Bien entendu, après cette durée de démarrage toutes les valeurs de phase ou variations de phase peuvent être mémorisées dans une mémoire (FIFO) principalement intégrée dans le contrôleur de démarrage conduisant à une fréquence du signal de l'oscillateur de référence dans une marge d'erreur acceptable lors d'un prochain démarrage de l'oscillateur à quartz. Principalement, il peut être mémorisé dans une mémoire de type non volatile, l'erreur de fréquences obtenues sur la base de variation de phases dans les périodes successives dans la durée de démarrage de l'oscillateur à quartz, ou après la fin du démarrage de l'oscillateur à quartz. La fréquence d'un tel oscillateur à quartz de type radio est généralement de l'ordre de 26 MHz ou plus.

Il est à noter qu'une fois que l'oscillateur à quartz est entièrement mis en fonction et que la fréquence de l'oscillateur de référence a été corrigée par exemple à + ou -1 % de la fréquence de l'oscillateur à quartz, il n'est plus nécessaire d'effectuer de modifications de paramètres pour garantir une précision de l'oscillateur de référence par rapport à l'oscillateur à quartz, sauf en cas de dérives des paramètres dans le temps.

Pour la mise en fonction adaptée du système oscillateur, il est tout d'abord décrit le procédé de mise en action ou d'entraînement du système électronique principalement dans une phase de démarrage avec une adaptation de fréquence basée sur la variation de phases dans chaque période successive d'adaptation du signal pour corriger la fréquence de l'oscillateur de référence.

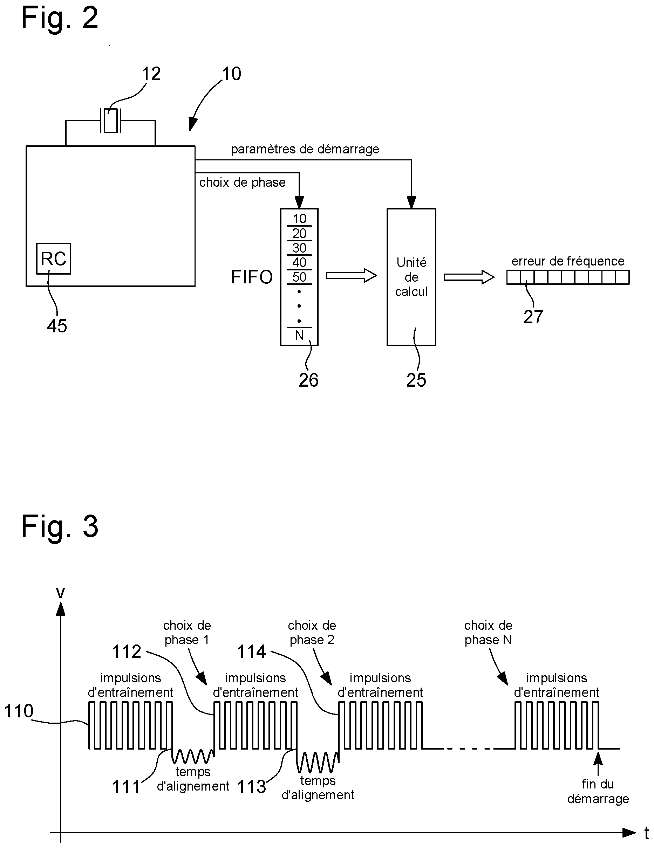

De manière plus détaillée, il est décrit le procédé de mise en action du système oscillateur en référence aux figures 2 et 3. Il est principalement déterminé un écart de phases lors de l'opération de démarrage rapide de l'oscillateur à quartz notamment à chaque réalignement de phases dans chaque période successive de signaux d'excitation de l'oscillateur à quartz générés par un contrôleur de démarrage 16 dans la durée de démarrage rapide de l'oscillateur à quartz, voire après la fin du démarrage de l'oscillateur à quartz. Il peut être prévu de définir une durée de démarrage comme paramètre de démarrage. Cette durée de démarrage peut être de l'ordre de la milliseconde ms voire supérieure ou inférieure.

Pour décrire le procédé d'entraînement du système oscillateur 10, il est fait référence à la figure 2. Les différents éléments du système oscillateur 10 sont disposés dans des portions symbolisant les différentes étapes du contrôle de la phase de manière à pouvoir corriger une erreur de fréquences. Dans la première partie du système oscillateur 10, il est représenté schématiquement l'oscillateur à quartz par son résonateur 12, et l'oscillateur de référence 45 de type RC. Le bloc comprenant l'oscillateur à quartz et l'oscillateur de référence 45 est une partie du contrôleur de démarrage, qui fournit des paramètres de démarrage à une unité de calcul 25, qui est de préférence un processeur ou un microcontrôleur. Ces paramètres de démarrage sont par exemple relatifs à l'excitation de l'oscillateur à quartz pour le faire osciller dans la durée de démarrage, et pour un contrôle de l'écart de phases par rapport à l'oscillateur de référence. Ces paramètres sont plus précisément le nombre d'impulsions d'entraînement ou d'excitation ("bursts" en terminologie anglaise) fournis à l'oscillateur à quartz, suivi par le temps d'alignement de phases, et il est également prévu de définir la durée de démarrage de l'oscillateur à quartz.

Sur chaque période successive, il doit être prévu un nombre sélectionné d'impulsions d'entraînement de l'oscillateur à quartz et un temps d'alignement de phases. Le nombre d'impulsions d'entraînement ou d'excitation de l'oscillateur à quartz peut être égal à 5 ou 10 ou 15 ou 20 impulsions dans chaque période successive de démarrage. Cela signifie que plus le nombre d'impulsions dans chaque période successive est grand, plus la fréquence de ces impulsions fournies est grande. De plus, il est encore remarqué qu'avec un plus grand nombre d'impulsions d'excitation dans chaque période successive, l'amplitude de l'oscillateur à quartz augmente plus rapidement qu'avec un moins grand nombre d'impulsions d'excitation de l'oscillateur à quartz.

Ces impulsions de démarrage peuvent être de l'ordre de 750 mV de crête à crête. Plusieurs périodes successives sont nécessaires dans une durée de démarrage du système oscillateur 10 complet, qui peut être fixé par exemple à 1 ms, voire à 1,5 ms. Depuis le bloc comprenant le contrôleur de démarrage, il est également fourni le choix de la valeur de phase pour chaque période successive d'adaptation de la phase. Principalement il est mémorisé notamment dans la mémoire 26, telle qu'une mémoire FIFO, des corrections de phases successives, qui peuvent être utilisées pour une autre opération de démarrage de l'oscillateur à quartz. L'unité de calcul 25 reçoit donc ces écarts de phases dans des périodes successives de manière à déterminer en fonction des paramètres de démarrage reçus une erreur de fréquences calculée lors du démarrage du système oscillateur 10 complet. Il est principalement déterminé la pente de variation de phases dans chaque période successive ou dans plusieurs périodes successives et il est effectué une dérivée de cette pente ce qui donne une erreur de fréquences à corriger entre la fréquence de l'oscillateur à quartz et la fréquence de l'oscillateur de référence.

Il est présenté à la figure 2 des changements de valeurs de phase dans ce cas de figure croissant de 10 à N par pas de 10 s'ajoutant à chaque valeur précédente dans la mémoire représentée 26. Mais bien entendu, il est tout à fait plausible qu'à partir d'une précédente adaptation de phase les valeurs sélectionnées suivantes de phase peuvent décroître par des pas inférieurs à 10 pour s'approcher d'une valeur de phase adéquate. Et finalement l'unité de calcul 25 détermine selon les variations de phases l'erreur de fréquences à corriger. L'unité de calcul 25 fournit dans un registre mémoire 27 l'erreur de fréquences pour adapter la fréquence d'oscillation de l'oscillateur de référence à la fréquence d'oscillation de l'oscillateur à quartz.

On peut remarquer à la figure 3, la génération d'une séquence de plusieurs signaux d'excitation 110, 112, 114 dans le temps ou durée de démarrage de l'oscillateur à quartz et entre chaque groupe de signaux d'excitation, les temps de réalignement de phases. Dans l'intervalle de temps de chaque réalignement de phases, il peut être observé les signaux d'oscillation individuels de l'oscillateur à quartz 111, 113 détectables entre les signaux d'excitation consécutifs 110, 112, 114. On remarque que les oscillations de l'oscillateur à quartz d'une séquence à l'autre, sont croissantes en amplitude, ce qui est recherché. La phase est réalignée jusqu'au terme du temps défini du démarrage de l'oscillateur à quartz. De plus, la fréquence d'oscillation de l'oscillateur de référence peut être corrigée sur la base de la détermination des écarts de phases et de la dérivée de pente de variations de phases lors du démarrage de l'oscillateur à quartz et dans le temps de démarrage déterminé

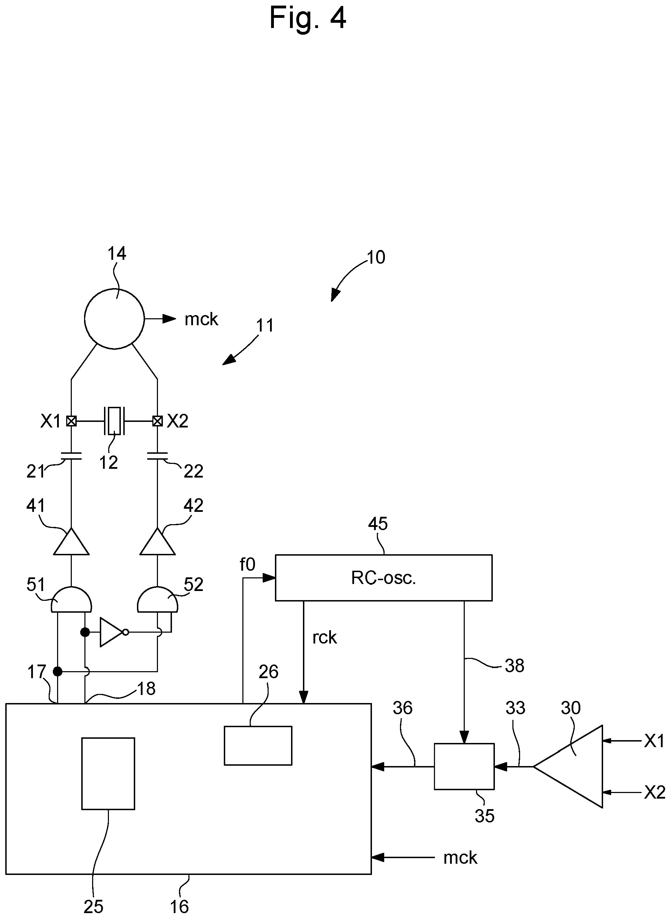

La figure 4 représente une première forme d'exécution d'un système oscillateur 10 à démarrage rapide avec un asservissement en phase pour corriger une erreur de fréquences de l'oscillateur de référence 45 sur la base de l'oscillateur à quartz 11. Le système oscillateur 10 comprend un étage oscillateur à quartz 11 équivalent à celui décrit en référence à la figure 1 de l'art antérieur. La correction d'erreur de fréquences est effectuée durant le temps du démarrage de l'oscillateur à quartz.

L'oscillateur 11 comprend donc un résonateur à quartz 12 lié à un circuit oscillateur électronique 14. Le résonateur à quartz 12 est électriquement couplé parallèlement au circuit oscillateur électronique 14. La structure de l'oscillateur 11 comprend une première borne X1 et une seconde borne X2, qui sont connectées respectivement aux première et seconde bornes du résonateur à quartz 12 et au circuit oscillateur électronique 14. La borne de sortie mck du circuit oscillateur électronique 14 est prévue pour fournir un signal d'horloge maître mck pour être utilisé par un dispositif électronique, qui peut être une montre portée par un utilisateur. Dans le cas présent, le signal d'horloge maître mck est fourni à un contrôleur de démarrage 16, qui est configuré et mis en fonction pour effectuer une procédure à démarrage rapide de l'oscillateur à quartz 11 par l'intermédiaire d'un oscillateur de référence 45. Comme précisé auparavant, l'oscillateur de référence 45 est de préférence un oscillateur de type RC, qui peut généralement être laissé en fonctionnement en continu à faible consommation. L'oscillateur de référence 45 doit au moins être mis en fonction avant d'effectuer une procédure de démarrage de l'oscillateur à quartz 11.

Le contrôleur de démarrage 16 comprend une unité de calcul 25, qui peut être un processeur 25 ou microcontrôleur ainsi qu'une unité mémoire 26 pour le stockage de données en liaison à l'oscillateur de référence 45 et pour le démarrage de l'oscillateur à quartz 11. L'unité mémoire 26 peut être constituée d'une mémoire de type RAM comme une mémoire FIFO par exemple. Le système oscillateur 10 comprend un comparateur 30, ayant une première borne d'entrée X1 connectée à la première borne de l'oscillateur à quartz 11, et une deuxième borne d'entrée X2 connectée à la deuxième borne de l'oscillateur à quartz 11. Le signal d'horloge maître mck peut également être présent mais principalement dédicacé au contrôleur de démarrage 16.

Le contrôleur de démarrage 16 comprend une sortie de phase 17 connectée à des première et deuxième portes logiques 51, 52, qui peuvent être des portes ET. L'entrée de la deuxième porte logique 52 est inversée par un inverseur 60 par rapport à l'entrée de la première porte logique 51. Les deux portes logiques 51, 52 sont en outre connectées à une sortie de contrôle de démarrage 18. Une sortie des première et deuxième portes logiques 51, 52 est connectée ou couplée aux premier et deuxième amplificateurs tampon 41, 42. Les sorties respectives des premier et deuxième amplificateurs tampon 41, 42 sont connectées aux premier et deuxième condensateurs 21, 22. Les condensateurs 21, 22 sont entraînés en mode déphasé par le contrôleur de démarrage 16.

Le système oscillateur 10 comprend en outre un synchroniseur 35. Le synchroniseur 35 comprend une borne d'entrée également désignée comme une entrée de synchronisation 33 ou sortie de comparateur 30. De cette façon, un signal comparatif indiquant une comparaison des premier et deuxième signaux d'oscillation présents aux première et deuxième bornes X1, X2 peut être fourni au synchroniseur 35.

L'oscillateur de référence 45, tel qu'un oscillateur de type RC, peut être contrôlé par le contrôleur de démarrage 16. Ici, de nombreuses fréquences ou principalement des écarts de phases menant au calcul d'erreurs de fréquence pour la conduite de l'oscillateur 45 peuvent être stockés dans l'unité de stockage 26. L'oscillateur de référence 45 reçoit en principe un signal de fréquence f0 provenant du contrôleur de démarrage 16. Il fournit également un signal de base de temps rck pour le contrôleur de démarrage 16 et est relié à une entrée d'horloge 38 du synchroniseur 35. La borne de sortie 36 du synchroniseur 35 est reliée directement au contrôleur de démarrage 16, dans lequel il est déterminé principalement des écarts de phases des signaux de l'oscillateur à quartz par rapport aux signaux de l'oscillateur de référence.

Comme indiqué ci-dessus, il est préféré déterminer une variation de phases plutôt que de déterminer immédiatement une erreur de fréquences à adapter. Avec la détermination de la variation de phases après le démarrage de l'oscillateur à quartz 11 et avec l'oscillateur de référence 45 continûment en fonction, la variation de phases entre le signal oscillant de l'oscillateur à quartz 11 et le signal oscillant de l'oscillateur de référence 45 est contrôlée dans le contrôleur de démarrage 16 sur la base du signal de sortie du synchroniseur 36. S'il y a un écart de phases, il est déterminé immédiatement l'écart de fréquences correspondant en effectuant uniquement une dérivée de l'écart de phases dans le contrôleur de démarrage 16. Une mémorisation dans l'unité mémoire 26 est effectuée de cet écart de fréquences relatif à l'écart de phases. Une fois que l'oscillateur à quartz 11 est maintenu en oscillation et sans variation de phases, l'écart de phases mémorisé peut permettre d'asservir l'oscillateur de référence 45 rapidement à une fréquence d'oscillation connue. Il est également effectué dans le temps plusieurs fois des mesures de réalignement de phases permettant de maintenir une précision de fréquence de l'oscillateur de référence 45 correspondant à de la fréquence de l'oscillateur à quartz dans une marge d'erreur de + ou -1 % de la fréquence de l'oscillateur à quartz 11.

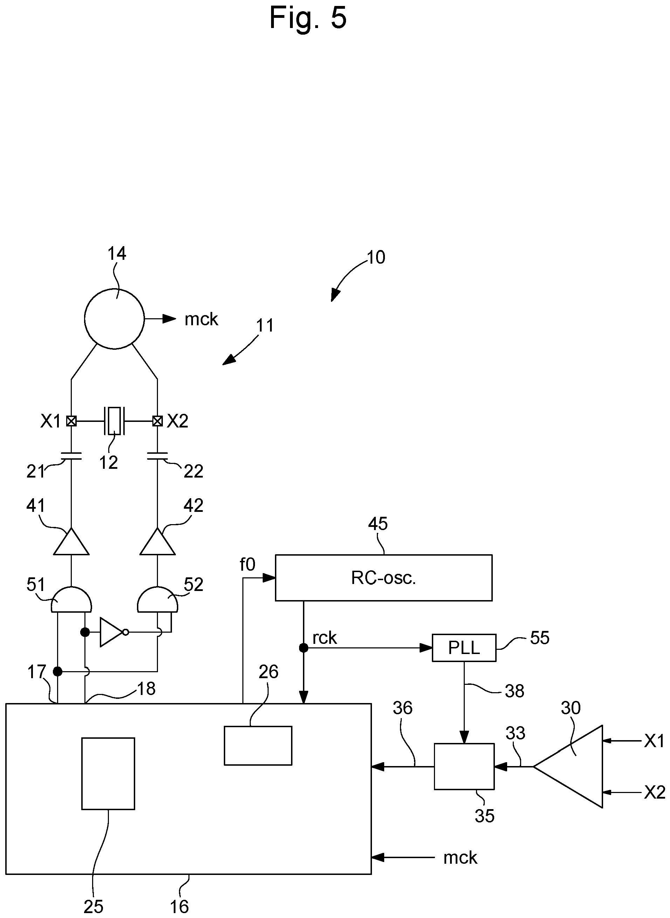

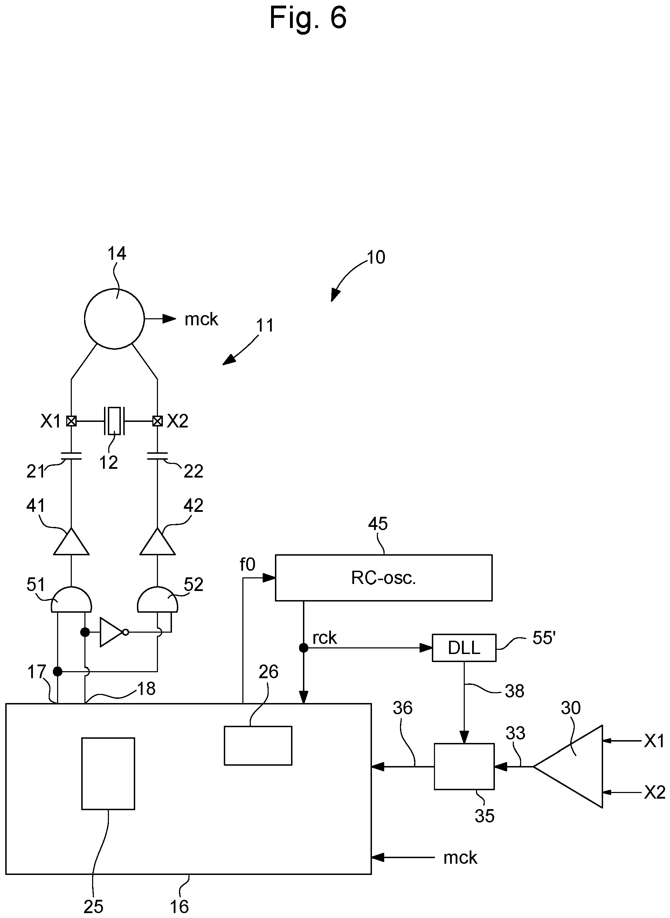

Les figures 5 et 6 représentent les deuxième et troisième variantes de réalisation du système oscillateur 10. Il ne sera pas répété l'ensemble des composants de ces deux figures 5 et 6 étant donné que l'unique différence par rapport à la première forme d'exécution représentée à la figure 4 se situe au niveau de l'entrée d'horloge 38 du synchroniseur 35.

A la figure 5, un signal de base de temps rck de l'oscillateur de référence 45 est fourni d'une part au contrôleur de démarrage 16 et d'autre part à une boucle à verrouillage de phase 55 (PLL), dont la borne de sortie est reliée à l'entrée d'horloge 38 du synchroniseur 35.

A la figure 6, un signal de base de temps rck de l'oscillateur de référence 45 est fourni d'une part au contrôleur de démarrage 16 et d'autre part à une boucle à retard de phase 55' (DLL), dont la borne de sortie est reliée à l'entrée d'horloge 38 du synchroniseur 35.

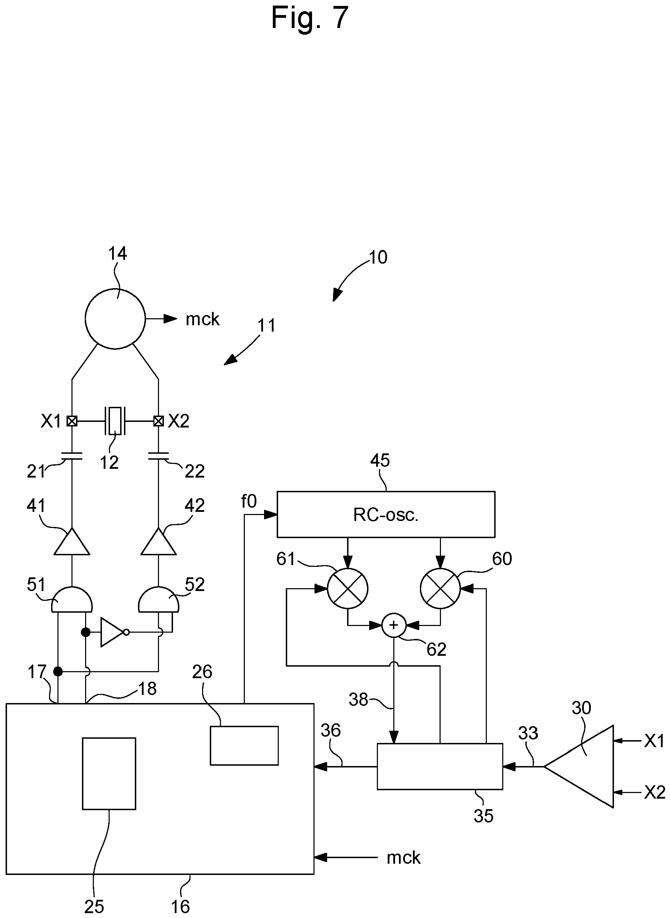

La figure 7 représente la quatrième forme d'exécution du système oscillateur 10 où il n'y a qu'une différence au niveau de l'oscillateur de référence 45, du synchroniseur 35 et contrôleur de démarrage 16. Tous les autres composants ont déjà été décrits dans la première forme d'exécution à la figure 4 ci-dessus et ne seront donc pas répétés pour cette quatrième forme d'exécution. Il est effectué pour chacune de ces variantes de réalisation la même détermination notamment des écarts de phases pour asservir l'oscillateur de référence afin d'avoir une fréquence corrigée précise sensiblement égale à la fréquence de l'oscillateur à quartz.

Sur la figure 7, on remarque encore deux mélangeurs 60, 61 recevant le signal de base de temps rck de l'oscillateur de référence 45, et chacun respectivement un signal du synchroniseur 35. La sortie de chacun de ces mélangeurs 60, 61 est fournie à un additionneur 62, dont la sortie est reliée à l'entrée d'horloge 38 du synchroniseur 35.

Bien entendu, d'autres possibilités d'effectuer le procédé de mise en action le système oscillateur et de réaliser le système oscillateur à démarrage rapide peuvent être envisagées par l'homme du métier sans sortir du cadre de l'invention définie par les revendications.

## Revendications

1. Procédé de mise en action d'un système oscillateur(10) à démarrage rapide, qui comprend un oscillateur de référence (45) et un oscillateur à quartz (11), qui comprend un résonateur à quartz (12) lié à un circuit oscillateur électronique (14), et des première et seconde bornes (X1, X2) connectées respectivement aux première et seconde bornes du résonateur à quartz (12) et du circuit oscillateur électronique (14), dont une borne de sortie est prévue pour fournir un signal d'horloge maître (mck) à un contrôleur de démarrage (16), qui est configuré et mis en fonction pour effectuer une procédure à démarrage rapide de l'oscillateur à quartz (11) par l'intermédiaire de l'oscillateur de référence (45), le contrôleur de démarrage (16) comprenant une unité de calcul (25) ainsi qu'une unité mémoire (26) pour le stockage de données en liaison à l'oscillateur de référence (45) et pour le démarrage de l'oscillateur à quartz (11), le procédé **se caractérisant en ce qu'**il comprend des étapes, pendant une durée de démarrage de l'oscillateur à quartz (11), ou après la fin du démarrage de l'oscillateur à quartz, qui consistent à :
- paramétrer l'unité de calcul (25) pour le démarrage de l'oscillateur à quartz (11),
- générer dans différentes périodes successives dans une durée de démarrage de l'oscillateur à quartz (11), des impulsions d'excitation à fournir à l'oscillateur à quartz (11), pour le faire osciller, et un temps de réalignement de phases,
- déterminer un écart de phases dans différentes périodes successives entre l'oscillation de l'oscillateur de référence et l'oscillation de l'oscillateur à quartz (11),
- calculer une erreur de fréquences dans l'unité de calcul (25) sur la base de l'écart de phases ou de la dérivée de la pente de variations de phases, et
- corriger la fréquence de l'oscillateur de référence (45) à la fréquence de l'oscillateur à quartz (11), dans une marge d'erreur limitée.

2. Procédé selon la revendication 1, **caractérisé en ce que** la durée de démarrage est définie avant le début du démarrage du système oscillateur, ou lors du paramétrage de l'unité de calcul (25).

3. Procédé selon la revendication 2, **caractérisé en ce que** la durée de démarrage est adaptable en fonction de précédentes mises en action du système oscillateur (10), et **en ce que** la durée de démarrage est définie de l'ordre de 1 ms ou 1,5 ms.

4. Procédé selon l'une des revendications précédentes, **caractérisé en ce que** le nombre d'impulsions d'excitation de l'oscillateur à quartz (11) est fixé avant le démarrage du système oscillateur (10), ou lors du paramétrage de l'unité de calcul (25) à une valeur égale à 5 ou 10 ou 15 ou 20 ou plus.

5. Procédé selon l'une des revendications précédentes, **caractérisé en ce que** le temps de réalignement de phases, ainsi que le nombre d'impulsions d'excitation sont définis pour chaque période successive dans la durée de démarrage, et **en ce que** dans chaque période successive, il est tout d'abord fourni le nombre défini impulsions d'excitation suivi, par le temps de réalignement de phases.

6. Procédé selon l'une des revendications précédentes, **caractérisé en ce qu'**il est effectué le calcul de l'erreur de fréquences sensiblement au terme de la durée de démarrage de l'oscillateur à quartz (11), sur la base de la variation de phases dans plusieurs périodes successives, ou après la fin du démarrage de l'oscillateur à quartz.

7. Procédé selon l'une des revendications précédentes, **caractérisé en ce que** l'oscillateur de référence (45) est maintenu continuellement en activité avant chaque démarrage de l'oscillateur à quartz (11) dans le système oscillateur (10).

8. Système oscillateur (10) à démarrage rapide destiné à être mis en action par le procédé selon l'une des revendications précédentes, le système oscillateur (10) comprenant un oscillateur de référence (45) et un oscillateur à quartz (11), qui comprend un résonateur à quartz (12) lié à un circuit oscillateur électronique (14), et des première et seconde bornes (X1, X2) connectées respectivement aux première et seconde bornes du résonateur à quartz (12) et du circuit oscillateur électronique (14), dont une borne de sortie est prévue pour fournir un signal d'horloge maître (mck) à un contrôleur de démarrage (16), qui est configuré et mis en fonction pour effectuer une procédure à démarrage rapide de l'oscillateur à quartz (11) par l'intermédiaire de l'oscillateur de référence (45), le contrôleur de démarrage (16) comprenant une unité de calcul (25) ainsi qu'une unité mémoire (26) pour le stockage de données en liaison à l'oscillateur de référence (45) et pour le démarrage de l'oscillateur à quartz (11),
**caractérisé en ce que** l'oscillateur de référence (45) est agencé pour fonctionner en continu de manière à déterminer tout écart de phases entre l'oscillateur de référence (45) et l'oscillateur à quartz (11) dans chaque durée de démarrage du système oscillateur (10) ou après la fin du démarrage de l'oscillateur à quartz, et destiné à déterminer directement selon une variation de phases, une erreur de fréquences de manière à pouvoir être corrigée au terme d'une durée de démarrage.

9. Système oscillateur (10) selon la revendication 8, **caractérisé en ce qu'**il comprend l'oscillateur de référence (45), qui est un oscillateur de type RC, destiné à être laissé en fonction en continu à faible consommation, **en ce que** le contrôleur de démarrage (16) comprend l'unité de calcul (25), qui est un processeur ou un microcontrôleur, et l'unité mémoire (26) pour le stockage de données en liaison à l'oscillateur de référence (45), **en ce que** le système oscillateur (10) comprend un comparateur (30), ayant une première borne d'entrée (X1) connectée à la première borne de l'oscillateur à quartz (11), et une deuxième borne d'entrée (X2) connectée à la deuxième borne de l'oscillateur à quartz (11), **en ce qu'**il comprend un synchroniseur (35) comprenant une entrée de synchronisation (33) ou sortie de comparateur (30), **en ce qu'**un signal de fréquence (f0) provenant du contrôleur de démarrage (16), est fourni à l'oscillateur (45), qui est destiné à fournir un signal de base de temps (rck) pour le contrôleur de démarrage (16), et est relié à une entrée d'horloge (38) du synchroniseur (35), et **en ce que** la borne de sortie (36) du synchroniseur (35) est reliée directement au contrôleur de démarrage (16), destiné à déterminer des écarts de phases des signaux de l'oscillateur à quartz (11) par rapport aux signaux de l'oscillateur de référence (45) lors d'un démarrage du système oscillateur (10).

10. Système oscillateur (10) selon la revendication 8, **caractérisé en ce qu'**il comprend l'oscillateur de référence (45), qui est un oscillateur de type RC, destiné à être laissé en fonction en continu à faible consommation, **en ce que** le contrôleur de démarrage (16) comprend l'unité de calcul (25), qui est un processeur ou un microcontrôleur, et l'unité mémoire (26) pour le stockage de données en liaison à l'oscillateur de référence (45), **en ce que** le système oscillateur (10) comprend un comparateur (30), ayant une première borne d'entrée (X1) connectée à la première borne de l'oscillateur à quartz (11), et une deuxième borne d'entrée (X2) connectée à la deuxième borne de l'oscillateur à quartz (11), **en ce qu'**il comprend un synchroniseur (35) comprenant une entrée de synchronisation (33) ou sortie de comparateur (30), **en ce qu'**un signal de fréquence (f0) provenant du contrôleur de démarrage (16), est fourni à l'oscillateur (45), qui est destiné à fournir un signal de base de temps (rck) d'une part au contrôleur de démarrage (16) et d'autre part à une boucle à verrouillage de phase (55), dont la borne de sortie est reliée à une entrée d'horloge (38) du synchroniseur (35), et **en ce que** la borne de sortie (36) du synchroniseur (35) est reliée directement au contrôleur de démarrage (16), destiné à déterminer des écarts de phases des signaux de l'oscillateur à quartz (11) par rapport aux signaux de l'oscillateur de référence (45) lors d'un démarrage du système oscillateur (10).

11. Système oscillateur (10) selon la revendication 8, **caractérisé en ce qu'**il comprend l'oscillateur de référence (45), qui est un oscillateur de type RC, destiné à être laissé en fonction en continu à faible consommation, **en ce que** le contrôleur de démarrage (16) comprend l'unité de calcul (25), qui est un processeur ou un microcontrôleur, et l'unité mémoire (26) pour le stockage de données en liaison à l'oscillateur de référence (45), **en ce que** le système oscillateur (10) comprend un comparateur (30), ayant une première borne d'entrée (X1) connectée à la première borne de l'oscillateur à quartz (11), et une deuxième borne d'entrée (X2) connectée à la deuxième borne de l'oscillateur à quartz (11), **en ce qu'**il comprend un synchroniseur (35) comprenant une entrée de synchronisation (33) ou sortie de comparateur (30), **en ce qu'**un signal de fréquence (f0) provenant du contrôleur de démarrage (16), est fourni à l'oscillateur (45), qui est destiné à fournir un signal de base de temps (rck) d'une part au contrôleur de démarrage (16) et d'autre part à une boucle à retard de phase (55'), dont la borne de sortie est reliée à une entrée d'horloge (38) du synchroniseur (35), et **en ce que** la borne de sortie (36) du synchroniseur (35) est reliée directement au contrôleur de démarrage (16), destiné à déterminer des écarts de phases des signaux de l'oscillateur à quartz (11) par rapport aux signaux de l'oscillateur de référence (45) lors d'un démarrage du système oscillateur (10).

12. Système oscillateur (10) selon la revendication 8, **caractérisé en ce qu'**il comprend l'oscillateur de référence (45), qui est un oscillateur de type RC avec un mélangeur IQ de synchronisation, destiné à être laissé en fonction en continu à faible consommation, **en ce que** le contrôleur de démarrage (16) comprend l'unité de calcul (25), qui est un processeur ou un microcontrôleur, et l'unité mémoire (26) pour le stockage de données en liaison à l'oscillateur de référence (45), **en ce que** le système oscillateur (10) comprend un comparateur (30), ayant une première borne d'entrée (X1) connectée à la première borne de l'oscillateur à quartz (11), et une deuxième borne d'entrée (X2) connectée à la deuxième borne de l'oscillateur à quartz (11), **en ce qu'**il comprend un synchroniseur (35) comprenant une entrée de synchronisation (33) ou sortie de comparateur (30), **en ce qu'**un signal de fréquence (f0) provenant du contrôleur de démarrage (16), est fourni à l'oscillateur (45), **en ce qu'**il comprend deux mélangeurs (60, 61) destiné à recevoir le signal de base de temps (rck) de l'oscillateur de référence (45), et chacun respectivement un signal du synchroniseur (35), **en ce que** la sortie de chacun des mélangeurs (60, 61) est fournie à un additionneur (62), dont la sortie est reliée à l'entrée d'horloge (38) du synchroniseur (35), et **en ce que** la borne de sortie (36) du synchroniseur (35) est reliée directement au contrôleur de démarrage (16), destiné à déterminer des écarts de phases des signaux de l'oscillateur à quartz (11) par rapport aux signaux de l'oscillateur de référence (45) lors d'un démarrage du système oscillateur (10).
